(19) ...

Europäisches
Patentamt

European
Patent Office

Office européen
des brevets

(11) **EP 1 959 573 B1**

(12) **EUROPEAN PATENT SPECIFICATION**

(45) Date of publication and mention
of the grant of the patent:
**22.08.2012   Bulletin 2012/34**

(51) Int Cl.:
***H03G 3/34*** *(2006.01)*          ***H04B 1/00*** *(2006.01)*

(21) Application number: **06833388.9**

(86) International application number:
**PCT/JP2006/323584**

(22) Date of filing: **27.11.2006**

(87) International publication number:
**WO 2007/066528 (14.06.2007 Gazette 2007/24)**

(54) **RECEPTION SENSITIVITY DETECTION DEVICE AND RECEPTION DEVICE**

VORRICHTUNG ZUR ERKENNUNG EINER AUFNAHMEEMPFINDLICHKEIT UND
AUFNAHMEVORRICHTUNG

DISPOSITIF DE DÉTECTION DE SENSIBILITÉ DE RÉCEPTION ET DISPOSITIF DE RÉCEPTION

(84) Designated Contracting States:
**DE FR GB**

(30) Priority:   **08.12.2005   JP 2005354667**

(43) Date of publication of application:
**20.08.2008   Bulletin 2008/34**

(73) Proprietor: **Pioneer Corporation
Kanagawa 212-0031 (JP)**

(72) Inventor: **SUGANUMA, Hisashi
Kawagoe-shi, Saitama 350-8555 (JP)**

(74) Representative: **Sajda, Wolf E. et al
Meissner, Bolte & Partner GbR
Postfach 86 06 24
81633 München (DE)**

(56) References cited:
**EP-A2- 1 526 642          JP-A- 7 231 270
JP-A- 2002 330 080      JP-A- 2004 297 574
JP-A- 2005 217 602**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to a reception sensitivity detector and a receiver for detecting the reception sensitivity, for example, of radio broadcasting from a modulated wave signal.

Background Art

Conventionally, such an FM receiver has been suggested which adjusts its detection output level based on a variation in reception sensitivity, thereby providing a noise suppression effect .

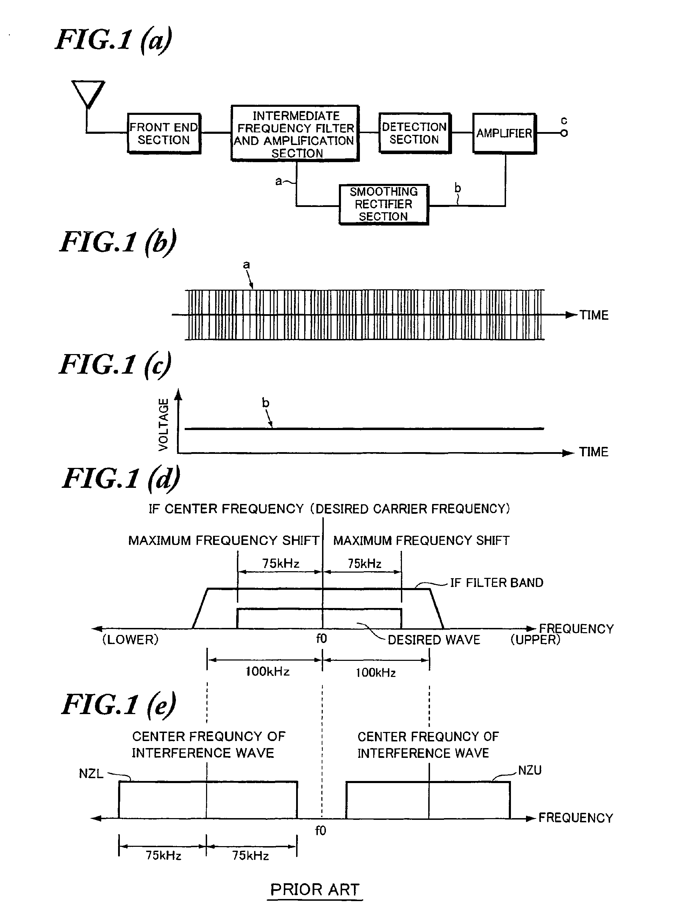

Fig. 1(a) is a block diagram illustrating the basic configuration of this conventional FM receiver. The receiver is configured such that an incoming radio wave is frequency converted at a frontend section to an intermediate frequency signal. The intermediate frequency signal is in turn band-restricted and amplified through an intermediate frequency filter and amplification section to thereby produce an intermediate frequency signal (IF signal) of a desired frequency band. The IF signal is detected at a detection section to thereby yield a detection output, which is then output through an amplifier.

Furthermore, a smoothing rectifier section serving as reception sensitivity detection means smoothly rectifies the aforementioned IF signal "a" produced in the intermediate frequency filter and amplification section, thereby producing an S meter signal "b" indicative of the reception sensitivity. The amplification factor of the aforementioned amplifier is automatically adjusted in accordance with the voltage level of the S meter signal "b", thereby adjusting the detection output level.

As schematically illustrated in Figs. 1(b) and (c), the FM receiver configured as described above provides the IF signal "a" which has an amplitude level associated with the receive field intensity of an incoming radio wave, and the S meter signal "b" which has a voltage level associated with the amplitude of the IF signal "a". It is thus believed that the amplification factor of the amplifier can be automatically adjusted in accordance with the voltage level of the S meter signal "b", thereby outputting a detection output "c" with a good S/N ratio.

Disclosure of the Invention

Problems to be Solved by the Invention

However, the aforementioned conventional FM receiver has a problem that it cannot correctly detect the reception sensitivity because an adjacent interference wave interfering with the frequency band occupied by the IF signal causes a variation in the voltage level of the S meter signal due to the effects of the interference wave.

That is, for example, in the case of the FM broadcasting in Japan, the channel frequency band of each broadcast station is allocated at intervals of approximately 100 kHz in a reception frequency band. In contrast to this, as schematically illustrated in Fig. 1(d), the intermediate frequency filter in an FM receiver for receiving FM broadcasts is designed to have a bandwidth of approximately +/- 100 kHz around a center frequency (carrier frequency) fo. The IF signal (modulated wave) that is FM modulated with the frequencies of +/- 75 kHz employed as the maximum frequency shift, thereby making it possible to provide reproduced sound.

Additionally, to prevent interference within a predetermined coverage area, the channel frequency bands of broadcast stations within each predetermined coverage area are defined at intervals of frequencies of 200 kHz or more. However, upon distance reception of a broadcast wave from a broadcast station located in a coverage area outside the aforementioned coverage area (another coverage area), a broadcast wave received from the broadcast station may be deviated by approximately +/- 100 kHz. As illustrated in Fig. 1(e), the intermediate frequency components of its adjacent broadcast waves may act as an adjacent interference wave NZL or NZU to interfere with the frequency band occupied by the IF signal.

Accordingly, the smoothing rectifier section serving as the reception sensitivity detection means provided in the conventional FM receiver may be able to smoothly rectify the IF signal mixed with an adjacent interference wave, but only by compromising the accurate detection of the intrinsic reception sensitivity of the desired wave.

Furthermore, since the reception sensitivity is typically a critical parameter used in various processing circuits within the receiver, it is important to suppress the effects of adjacent interferences and thereby produce an accurate S meter signal.

The present invention was developed in view of these conventional problems. It is therefore an object of the present invention to provide a reception sensitivity detector which suppresses the effects of adjacent interferences and detects reception sensitivity with accuracy.

It is another object of the present invention to provide a receiver which provides an improved noise suppression effect based on the reception sensitivity detected with accuracy.

The preamble of independent claims 1 and 4 is based on EP 1526642.

Means of Solving the Problems

The invention according to claim 1 provides a reception sensitivity detector for detecting a reception sensitivity from a modulated wave signal. The detector is characterized by including:

lower narrowband filter means having a passband width of a predetermined low frequency range including a carrier frequency of the modulated wave signal, the lower narrowband filter means extracting a lower signal component within the passband width from the modulated wave signal;
upper narrowband filter means having a passband width of a predetermined high frequency range including the carrier frequency of the modulated wave signal, the upper narrowband filter means extracting an upper signal component within the passband width from the modulated wave signal;
lower envelope detection means for detecting an envelope of the lower signal component; upper envelope detection means for detecting an envelope of the upper signal component;
first peak hold means for holding a peak of a lower envelope signal detected in the lower envelope detection means to thereby produce a smoothing signal;
second peak hold means for holding a peak of an upper envelope signal detected in the upper envelope detection means to thereby produce a smoothing signal; and
selector means for selecting a smoothing signal of a lower level between the smoothing signals produced in the first and second peak hold means to produce a reception sensitivity signal indicative of reception sensitivity.

The invention according to claim 2 provides a reception sensitivity detector for detecting a reception sensitivity from a modulated wave signal. The detector is characterized by including:

lower narrowband filter means having a passband width of a predetermined low frequency range including a carrier frequency of the modulated wave signal, the lower narrowband filter means extracting a lower signal component within the passband width from the modulated wave signal;
upper narrowband filter means having a passband width of a predetermined high frequency range including the carrier frequency of the modulated wave signal, the upper narrowband filter means extracting an upper signal component within the passband width from the modulated wave signal;
lower envelope detection means for detecting an envelope of the lower signal component; upper envelope detection means for detecting an envelope of the upper signal component;
first upstream selector means for comparing levels between a lower envelope signal detected in the lower envelope detection means and an upper envelope signal detected in the upper envelope detection means, wherein the lower envelope signal is employed as a first pre-signal when the level of the lower envelope signal is greater than the level of the upper envelope signal, while a first pre-signal of a ground level is produced when the level of the lower envelope signal is less than the level of the upper envelope signal;
second upstream selector means for comparing the levels between the lower envelope signal detected in the lower envelope detection means and the upper envelope signal detected in the upper envelope detection means, wherein the upper envelope signal is employed as a second pre-signal when the level of the upper envelope signal is greater than the level of the lower envelope signal, while a second pre-signal of the ground level is produced when the level of the upper envelope signal is less than the level of the lower envelope signal;
first quick-charge slow-discharge means for producing a smoothing signal by performing a quick-charge slow-discharge operation on the first pre-signal produced in the first upstream selector means;
second quick-charge slow-discharge means for producing a smoothing signal by performing a quick-charge slow-discharge operation on the second pre-signal produced in the second upstream selector means; and
downstream selector means for selecting a smoothing signal of a lower level between the smoothing signals produced in the first and second quick-charge slow-discharge means to produce a reception sensitivity signal indicative of reception sensitivity.

The invention according to claim 3 provides a receiver which is characterized by including automatic reception control means for providing automatic reception control to a detection output detected based on the modulated wave signal in accordance with the reception sensitivity signal produced by the reception sensitivity detector according to claim 1 or 2.

Brief Description of the Drawings

Fig. 1    shows a block diagram illustrating the configuration of and an explanatory view illustrating the function of a conventional reception sensitivity detector.

Fig. 2    shows a block diagram illustrating the configuration of and an explanatory view illustrating the function of a reception sensitivity detector according to an embodiment.

Fig. 3    is a block diagram illustrating the configuration of a reception sensitivity detector and a receiver according to an example.

Fig. 4    is an explanatory view illustrating the function of the reception sensitivity detector shown in Fig. 3.

Fig. 5    is a waveform diagram illustrating an exemplary operation of the reception sensitivity detector shown in Fig. 3.

Fig. 6    is a waveform diagram further illustrating an exemplary operation of the reception sensitivity detector shown in Fig. 3.

Best Mode for Carrying Out the Invention

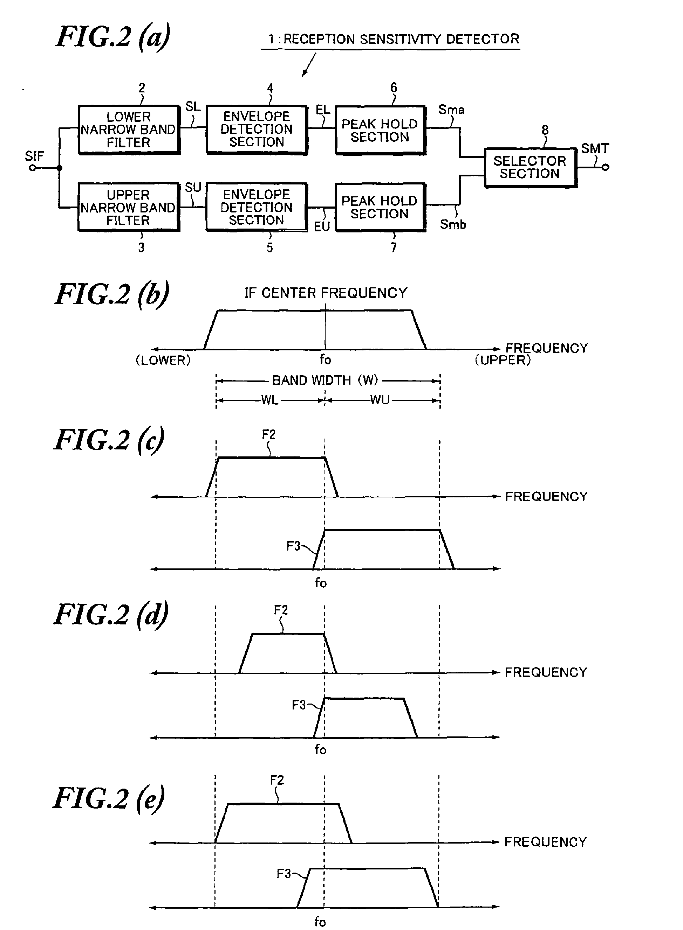

With reference to Fig. 2, a description will be made to a preferred embodiment of the present invention. Fig. 2 (a) is a block diagram illustrating the configuration of a reception sensitivity detector of the present embodiment. Figs. 2(b) to (e) are explanatory views schematically illustrating the frequency characteristics of an intermediate frequency filter, and a lower narrowband filter and an upper narrowband filter to be discussed later.

In Fig. 2(a), this reception sensitivity detector 1 is configured to include a lower narrowband filter 2, an upper narrowband filter 3, envelope detection sections 4 and 5, peak hold sections 6 and 7, and a selector section 8. The reception sensitivity detector 1 produces a reception sensitivity signal (hereinafter referred to as an "S meter signal") SMT indicative of reception sensitivity from a modulated wave signal (IF signal) SIF which is band-limited to a predetermined bandwidth W by an intermediate frequency filter (not shown) provided in an FM receiver, and then outputs the resulting signal SMT.

That is, a frontend section in the FM receiver mixes a local signal and a received high frequency signal (RF signal) to thereby produce a frequency-converted intermediate frequency signal. Then, the aforementioned intermediate frequency filter having a passband width W around a center frequency (carrier frequency) fo as shown in Fig. 2(b) band-restricts the intermediate frequency signal to thereby extract the IF signal SIF. The IF signal SIF is in turn received by the reception sensitivity detector 1.

As illustrated in Fig. 2(c), the lower narrowband filter 2 is formed of a band-pass filter with a passband width F2. The passband width F2 is so set as to have at least part of a frequency range, including the aforementioned center frequency fo, down to a low-band cutoff frequency (fo-W/2) of the intermediate frequency filter (hereinafter referred to as a "lower sideband") WL. The lower narrowband filter 2 extracts a signal component SL within the passband width F2 (hereinafter referred to as a "lower signal component") from the IF signal SIF or a modulated wave signal for output.

The passband width F2 is determined as described above, thereby allowing the lower narrowband filter 2 to make full use of its filter characteristics as follows. That is, the lower narrowband filter 2 always passes a carrier component (a component at the carrier frequency fo) or a signal component which is required to detect the reception sensitivity irrespective of the occurrence of interference with adjacent waves.
Furthermore, when an upper sideband WU is interfered with adjacent waves, the lower narrowband filter 2 does not pass the adjacent interference waves within the upper sideband WU. On the other hand, when the lower sideband WL is interfered with adjacent waves, the lower narrowband filter 2 passes the adjacent interference waves within the lower sideband WL.

As illustrated also in Fig. 2(c), the upper narrowband filter 3 is formed of a band-pass filter with a passband width F3. The passband width F3 is so set as to have at least part of a frequency range, including the aforementioned center frequency fo, up to a high-band cut-off frequency (fo + W/2) of the intermediate frequency filter (hereinafter referred to as an "upper sideband") WU. The upper narrowband filter 3 extracts a signal component SU within the passband width F3 (hereinafter referred to as an "upper signal component") from the IF signal SIF for output.

The passband width F3 is determined as described above, thereby allowing the upper narrowband filter 3 to make full use of its filter characteristics as follows. That is, the upper narrowband filter 3 always passes a carrier component (a component at the carrier frequency fo) or a signal component which is required to detect the reception sensitivity irrespective of the occurrence of interference with adjacent waves.
Furthermore, when the lower sideband WL is interfered with adjacent waves, the upper narrowband filter 3 does not pass the adjacent interference waves within the lower sideband WL. On the other hand, when the upper sideband WU is interfered with adjacent waves, the upper narrowband filter 3 passes the adjacent interference waves within the upper sideband WU.

Furthermore, the passband widths F2 and F3 as illustrated in Fig. 2(c) are each defined within a frequency range which includes the center frequency fo and generally covers the lower sideband WL or the upper sideband WU. However, in a modified example as illustrated in Fig. 2(d), the passband widths F2 and F3 may also be defined to have part of the frequency range of the lower sideband WL including the center frequency fo and part of the frequency range of the upper sideband WU including the center frequency fo, respectively.

Furthermore, in another modified example as illustrated in Fig. 2(e), the passband width F2 may also be defined to include not only the lower sideband WL and the center frequency fo but also part of the frequency range of the upper sideband WU (however, only such a frequency range that does not allow passage of adjacent interference waves from adjacent broadcast channels that interfere with the upper sideband WU).
On the other hand, the passband width F3 may also be defined to include not only the upper sideband WU and the center frequency fo but also part of the frequency range of the lower sideband WL (however, only such a frequency range that does not allow passage of adjacent interference waves from adjacent broadcast channels that interfere with the lower sideband WL).

In summary, for example, when the FM receiver is tuned during manufacturing, both the passband widths F2 and F3 are so determined as to include the center frequency fo and the frequency range of adjacent interference waves which are expected to possibly interfere with the bandwidth W of the intermediate frequency filter. This is because each broadcast station is assigned a different channel frequency band depending on the location or area where the FM receiver is used, for example, in Japan or abroad.

However, it is preferable that the passband width F2 and the passband width F3 be so determined as not to allow the passage of adjacent interference waves which interfere with the upper sideband WU and with the lower sideband WL, respectively. Additionally, the passband width F2 and the passband width F3 are preferably determined to have those frequency ranges symmetric to each other with respect to the center frequency fo.

The envelope detection section 4 is formed to have a rectifier, a filter circuit having a predetermined time constant and other components, and detects the envelope of the lower signal component SL, thereby outputting a lower envelope signal EL indicative of the envelope of the lower signal component SL.

The envelope detection section 5 is formed to have a rectifier, a filter circuit having a predetermined time constant and other components, and detects the envelope of the upper signal component SU, thereby outputting an upper envelope signal EU indicative of the envelope of the upper signal component SU.

The peak hold section 6 is formed of a charge and discharge circuit having a predetermined time constant and other components, and holds the peak of the lower envelope signal EL in accordance with the time constant, thereby producing a first smoothing signal Sma for output.

Likewise, the peak hold section 7 is also formed of a charge and discharge circuit having a predetermined time constant and other components, and holds the peak of the upper envelope signal EU in accordance with the time constant, thereby producing a second smoothing signal Smb for output.

The selector section 8 sequentially compares instantaneous amplitudes between the first and second smoothing signals Sma and Smb whose peaks are held in accordance with the aforementioned time constants to output the smoothing signal of the lower level as the S meter signal SMT indicative of the reception sensitivity.

That is, when the level of the first smoothing signal Sma is greater than the level of the second smoothing signal Smb, the selector section 8 determines that an adjacent interference wave is likely interfering with the lower sideband WL causing the level of the first smoothing signal Sma to be greater than the level of the second smoothing signal Smb. Then, the selector section 8 outputs the second smoothing signal Smb of the lower level as the S meter signal SMT.
On the other hand, when the level of the second smoothing signal Smb is greater than the level of the first smoothing signal Sma, the selector section 8 determines that an adjacent interference wave is likely interfering with the upper sideband WU causing the level of the second smoothing signal Smb to be greater than the level of the first smoothing signal Sma. Then, the selector section 8 outputs the first smoothing signal Sma of the lower level as the S meter signal SMT.

A description will now be made to the operation of the reception sensitivity detector 1 which is configured in this manner.

The IF signal SIF is supplied to the lower narrowband filter 2 and the upper narrowband filter 3, which are shown in Fig. 2(a). Then, the lower signal component SL and the upper signal component SU which have been band-limited respectively to the passband widths F2 and F3 are extracted. Subsequently, the envelope detection sections 4 and 5 deliver the lower envelope signal EL and the upper envelope signal EU, respectively. Furthermore, the peaks of the lower envelope signal EL and the upper envelope signal EU are held in the peak hold sections 6 and 7, thereby producing the first and second smoothing signals Sma and Smb, respectively.

In this instance, suppose that an adjacent interference wave interferes with the lower sideband WL of the bandwidth W of the intermediate frequency filter shown in Fig. 2(b) allowing the IF signal SIF to be mixed with the adjacent interference wave. This causes the level (instantaneous amplitude) of the first smoothing signal Sma to be greater than the level (instantaneous amplitude) of the second smoothing signal Smb, thereby allowing the selector section 6 to output the second smoothing signal Smb of the lower level as the S meter signal SMT that has not been affected by the adjacent interference.

On the other hand, an adjacent interference wave may interfere with the upper sideband WU of the bandwidth W of the intermediate frequency filter allowing the IF signal SIF to be mixed with the adjacent interference wave. This causes the level (instantaneous amplitude) of the second smoothing signal Smb to be greater than the level (instantaneous amplitude) of the first smoothing signal Sma, thereby allowing the selector section 6 to output the first smoothing signal Sma of the lower level as the S meter signal SMT that has not been affected by an adjacent interference.

On the other hand, when no adjacent interference wave interferes with the lower sideband WL and the upper sideband WU, it is indefinite which level is less than the other, the first smoothing signal Sma or the second smoothing signal Smb. However, since both the smoothing signals have not been affected by an adjacent interference, the smoothing signal of the lower level is selected, thereby producing the S meter signal SMT that has not been affected by the adjacent interference.

As described in the foregoing, in the reception sensitivity detector 1 of the present embodiment, the bandwidth W of the intermediate frequency filter is divided into the lower sideband WL and the upper sideband WU. Then, a smoothing signal is produced in accordance with the lower level of the IF signal SIF components within the lower sideband WL and within the upper sideband WU for output as the S meter signal SMT. It is thus possible to suppress the effects of adjacent interference waves and thereby produce the S meter signal SMT indicative of accurate reception sensitivity.

Thus, gain control or the like can be provided to detected output in accordance with the voltage level of the S meter signal SMT produced by the reception sensitivity detector 1 of the present embodiment, thereby implementing a receiver with an improvement such as in the S/N ratio. Furthermore, control can be provided to those various processing circuits included in the receiver in accordance with the voltage level of the S meter signal SMT, thereby allowing receptions with high quality.

Note that the present embodiment has two branches, i.e., a first branch and a second branch. The first branch includes the narrowband filter 2, the envelope detection section 4, and the peak hold section 6 to detect the presence of an interference wave interfering with the lower sideband WL. The second branch includes the narrowband filter 3, the envelope detection section 5, and the peak hold section 7 to detect the presence of an interference wave interfering with the upper sideband WU.

However, a modified example may also include an increased number of branches, which each include a narrowband filter, an envelope detection section, and a peak hold section, so that the lowest level of those smoothing signals produced in each of the branches can be employed as the S meter signal SMT. According to such a modified example, it is possible to produce the S meter signal SMT indicative of more accurate reception sensitivity.

However, even in the case of this modified example, the passband width of each narrowband filter is desirably designed to include at least the center frequency (carrier frequency) fo. The number of lower narrowband filters for the lower sideband WL should be the same as that of upper narrowband filters for the upper sideband WU.

Furthermore, pairs of narrowband filters should also be employed, each pair having symmetric passband widths with respect to the center frequency fo. Furthermore, passband widths may be defined so that each lower narrowband filter does not pass an adjacent interference wave interfering with the upper sideband WU, while each upper narrowband filter does not pass an adjacent interference wave interfering with the lower sideband WL.

[Example]

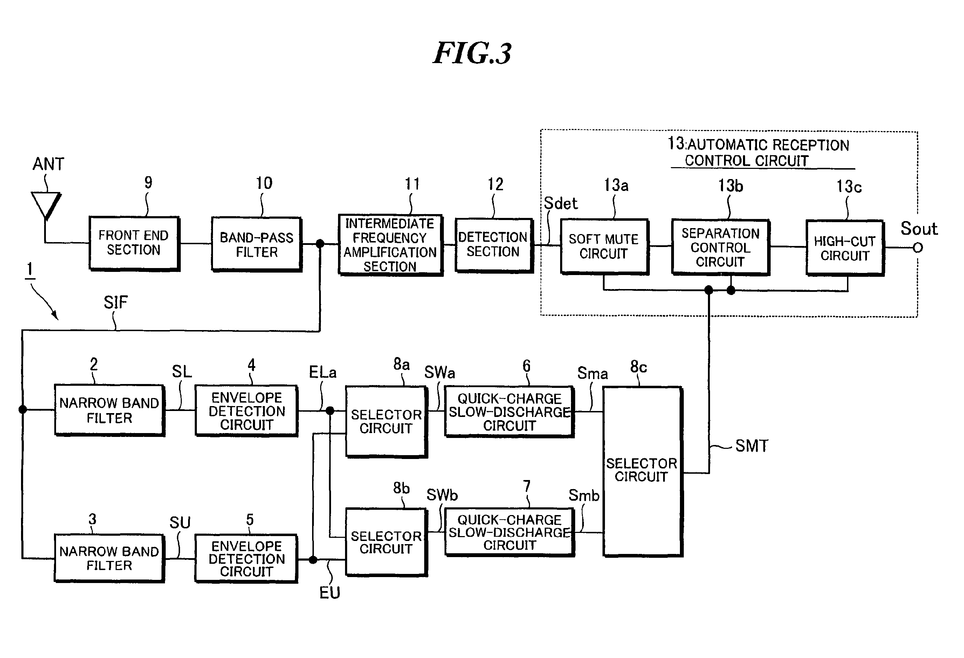

Now, with reference to Figs. 3 to 6, a description will be made to a reception sensitivity detector according to an example. Fig. 3 is a block diagram illustrating the configuration of the reception sensitivity detector of the present example, which is incorporated into an FM receiver. Furthermore, the components in Fig. 3 that are identical or equivalent to those of Fig. 2(a) are indicated with like symbols or like prefix symbols with a suffix.

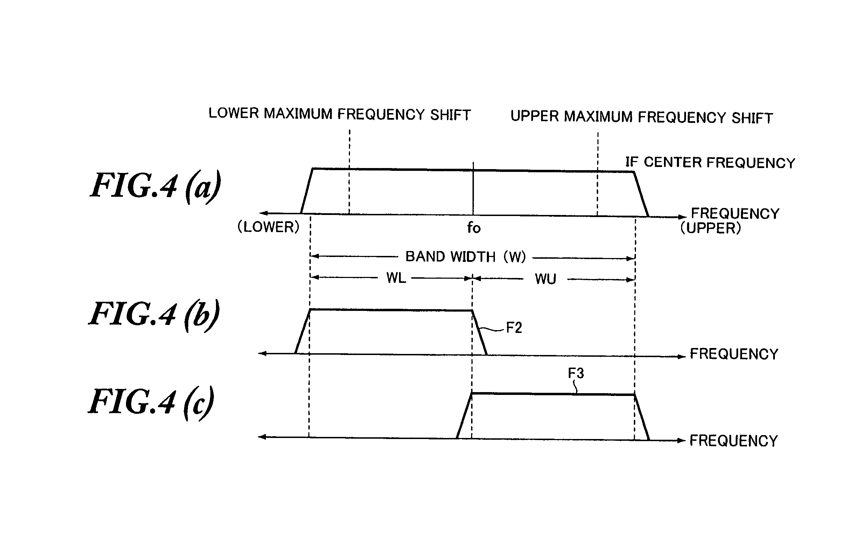

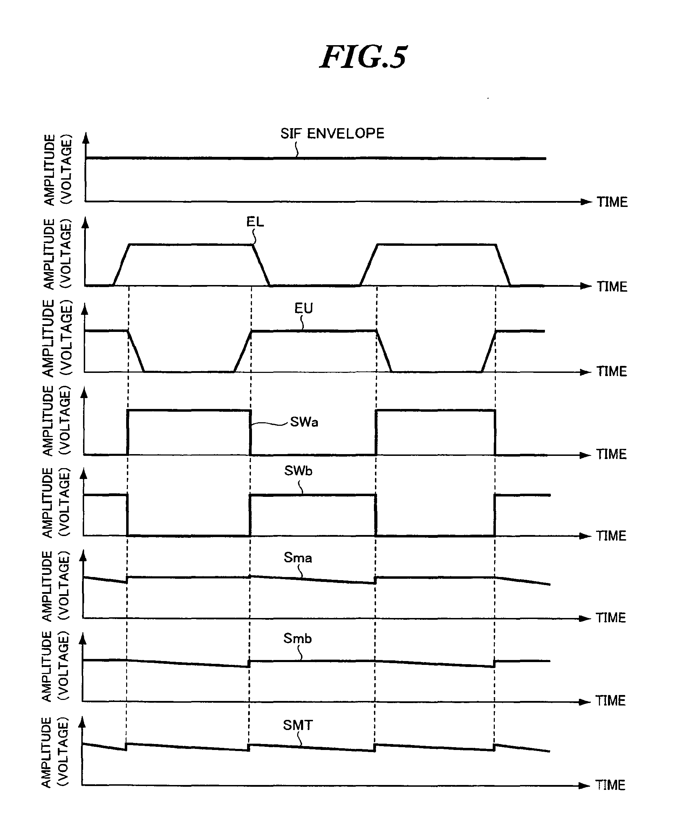

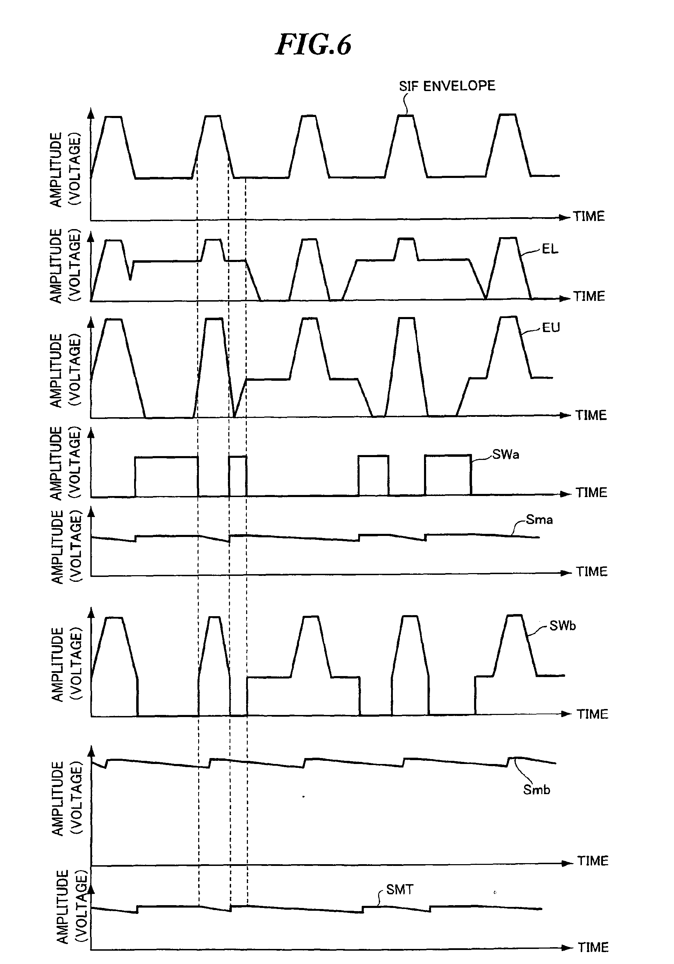

Fig. 4 shows the filter characteristics (passband widths) of an intermediate frequency filter included in the FM receiver, and a lower narrowband filter and an upper narrowband filter which are included in the reception sensitivity detector. Figs. 5 and 6 are schematic waveform diagrams showing the waveforms of the input or output signal of each component included in the reception sensitivity detector, with the waveforms shown on the same time axis throughout the diagrams.

First, with reference to Fig. 3, a description will be made to the basic configuration of the FM receiver. The FM receiver includes an antenna ANT for receiving an incoming radio wave such as broadcast waves; a frontend section 9 for mixing a local signal for selecting a channel and the received high frequency signal (RF signal) delivered from the antenna ANT to provide a frequency-converted intermediate frequency band signal; a band-pass filter (intermediate frequency filter) 10 for band-restricting the intermediate frequency band signal to the predetermined passband width W to thereby produce an intermediate frequency signal (IF signal) SIF; an intermediate frequency amplification section 11 for amplifying the IF signal SIF for supply to a detection section 12; and an automatic reception control circuit 13 for receiving a detection output (i.e. a demodulated signal) Sdet, which has been FM detected at the detection section 12, and for providing automatic reception control to the detection output Sdet, as will be discussed later, to output the resulting signal.

In this instance, the FM receiver may be designed to conform to the FM broadcasting in Japan, in the case of which the band-pass filter 10 has a center frequency (carrier frequency) fo of 10.7 MHz and a bandwidth W in a frequency range of approximately +/- 100 kHz around the center frequency fo.

The automatic reception control circuit 13 has a soft mute circuit 13a, a separation control circuit 13b, and a high-cut circuit 13c. Each of the circuits 13a, 13b, and 13c provides the predetermined automatic reception control to the demodulated signal Sdet in accordance with the voltage level of the S meter signal SMT. This is done, for example, when a variation occurs in the field strength of incoming radio waves depending on the distance from the transmit antenna of a transmit station to the receive antenna ANT or when fading occurs in incoming radio waves due to a building or geographical features in the radio transmission path. It is thus made possible to produce and deliver an output signal Sout which provides the user with reproduced sound with good sound quality.

More specifically, the soft mute circuit 13a is formed of an electronic attenuator (attenuation circuit), and gradually attenuates the amplification factor of the demodulated signal Sdet from 0 [dB] when the voltage level of the S meter signal SMT becomes less than the predetermined value due to the aforementioned fading or the like. The demodulated signal Sdet is gradually muted in this manner, thereby producing a signal with grating noise components suppressed for output as the output signal Sout.

When the voltage level of the S meter signal SMT becomes less than the predetermined value due to the aforementioned fading or the like, the separation control circuit 13b stops stereophonic reproduction based on the demodulated signal Sdet to provide control to monophonic reproduction, thereby outputting the monophonically reproduced signal as the output signal Sout.

The high-cut circuit 13c is formed of a high-frequency cutoff filter (in other words, low-pass filter) which can automatically tune its cutoff frequency. As the voltage level of the S meter signal SMT is reduced due to the aforementioned fading or the like, the high-cut circuit 13c reduces its cutoff frequency to thereby eliminate the high frequency components of the demodulated signal Sdet. Then, the high-cut circuit 13c outputs the signal with the high frequency components eliminated, i.e., a signal with high-frequency grating noise components suppressed, as the output signal Sout.

Then, with each of the circuits 13a, 13b, and 13c connected in series as illustrated, these circuits 13a, 13b, and 13c having each of the aforementioned automatic reception control functions perform predetermined processing on the signal to produce the output signal Sout, which is in turn delivered to a speaker (not shown).

However, each of the circuits 13a, 13b, and 13c may also be connected in parallel to the output from the detection section 12 instead of each of the circuits 13a, 13b, and 13c being connected in series with the output from the detection section 12. In this case, the automatic reception control may be provided as follows. That is, the relation between the voltage level of the S meter signal SMT and each effect of the automatic reception control functions provided by each of the circuits 13a, 13b, and 13c may be analyzed in accordance with a predetermined algorithm. Thus, any one of the circuits 13a, 13b, and 13c that can provide the user with the best listening environment may be selected, thereby only the output signal from the selected circuit to be output as the output signal Sout.

A description will now be made to the configuration of the reception sensitivity detector 1. The reception sensitivity detector 1 of the present example is configured to include the lower narrowband filter 2 and the upper narrowband filter 3 for receiving the IF signal SIF, the envelope detection circuits 4 and 5, quick-charge slow-discharge circuits 6 and 7, upstream selector circuits 8a and 8b, and a downstream selector circuit 8c.

The lower narrowband filter 2 is formed of a band-pass filter having a predetermined passband width F2. Within a bandwidth W of the band-pass filter 10 shown in Fig. 4(a), the passband width F2 is defined to have a frequency range which covers a center frequency fo and a lower sideband WL as shown in Fig. 4(b). The lower narrowband filter 2 allows a signal component of the IF signal SIF to pass through the passband width F2 for output as the lower signal component SL.

The passband width F2 is determined as described above, so that the lower narrowband filter 2 makes full use of its filter characteristics as follows. That is, the lower narrowband filter 2 always passes a carrier component (a component at the carrier frequency fo) or a signal component which is required to detect the reception sensitivity irrespective of the occurrence of interference with adjacent waves.

Furthermore, when the upper sideband WU is interfered with adjacent waves, the lower narrowband filter 2 does not pass the adjacent interference waves within the upper sideband WU. On the other hand, when the lower sideband WL is interfered with adjacent waves, the lower narrowband filter 2 passes the adjacent interference waves within the lower sideband WL.

The upper narrowband filter 3 is formed of a band-pass filter having a predetermined passband width F3. As shown in Fig. 4(c), the passband width F3 is defined to have a frequency range which covers the center frequency fo and an upper sideband WU. The upper narrowband filter 3 allows a signal component of the IF signal SIF to pass through the passband width F3 for output as the upper signal component SU.

The passband width F3 is determined as described above, so that the upper narrowband filter 3 makes full use of its filter characteristics as follows. That is, the upper narrowband filter 3 always passes a carrier component (a component at the carrier frequency fo) or a signal component which is required to detect the reception sensitivity irrespective of the occurrence of interference with adjacent waves.

Furthermore, when the lower sideband WL is interfered with adjacent waves, the upper narrowband filter 3 does not pass the adjacent interference waves within the lower sideband WL. On the other hand, when the upper sideband WU is interfered with adjacent waves, the upper narrowband filter 3 passes the adjacent interference waves within the upper sideband WU.

The envelope detection circuit 4 detects the envelope of the lower signal component SL to produce a lower envelope detection signal EL for output.

Likewise, the envelope detection circuit 5 detects the envelope of the upper signal component SU to produce an upper envelope detection signal EU for output.

The upstream selector circuits 8a and 8b and the downstream selector circuit 8c are equivalent to the selector section 8 shown in Fig. 2(a). However, the upstream selector circuits 8a and 8b are provided to sufficiently eliminate the effects of adjacent interference waves on the lower envelope detection signal EL and the upper envelope detection signal EU. On the other hand, the downstream selector circuit 8c is provided to produce the S meter signal SMT from the first smoothing signal Sma and the second smoothing signal Smb.

First, the upstream selector circuit 8a, which is formed of a comparator, an analog switch and the like, compares instantaneous amplitude levels between the lower envelope signal EL and the upper envelope signal EU to output a first pre-signal SWa in accordance with the comparison result as expressed by the equations (1a) and (1b) below.

### Equation 1

$$SWa = EL \text{ when } EL \geq EU \qquad \ldots(1a)$$
$$SWa = 0 \text{ when } EL < EU \qquad \ldots(1b).$$

That is, the upstream selector circuit 8a outputs the lower envelope signal EL as the first pre-signal SWa when the level of the lower envelope signal EL is greater than or equal to the level of the upper envelope signal EU ($EL \geq EU$). On the other hand, when the level of the lower envelope signal EL is less than the level of the upper envelope signal EU ($EL < EU$), the upstream selector circuit 8a compulsorily sets the level of the first pre-signal SWa to a ground level (0 Volt in the present example).

As described above, when the level of the lower envelope signal EL is greater than or equal to the level of the upper envelope signal EU ($EL \geq EU$), the upstream selector circuit 8a determines that no adjacent interference wave interferes with the lower sideband WL irrespective of whether any adjacent interference wave is interfering with the upper sideband WU. Then, the upstream selector circuit 8a outputs the lower envelope signal EL as the first pre-signal SWa.

On the other hand, when the level of the lower envelope signal EL is less than the level of the upper envelope signal EU ($EL < EU$), the upstream selector circuit 8a determines that an adjacent interference wave is likely interfering with the upper sideband WU, and thus does not output the upper envelope signal EU as the first pre-signal SWa. Furthermore, suppose that the upper sideband WU is interfered with an adjacent wave. In this case, the adjacent interference wave may also affect the lower envelope signal EL, so that the signal may be mixed with a so-called noise component or its waveform may be distorted. Thus, the upstream selector circuit 8a does not simply output the lower envelope signal EL as the first pre-signal SWa but compulsorily sets the first pre-signal SWa to the ground level, thereby eliminating the effects of the adjacent interference wave.

The upstream selector circuit 8b, which is formed of a comparator, an analog switch or the like, compares instantaneous amplitude levels between the lower envelope signal EL and the upper envelope signal EU to output a second pre-signal SWb in accordance with the comparison result as expressed by the equations (2a) and (2b) below.

### Equation 2

$$SWb = EU \text{ when } EU \geq EL \qquad \ldots(2a)$$
$$SWb = 0 \text{ when } EU < EL \qquad \ldots(2b).$$

That is, the upstream selector circuit 8b outputs the upper envelope signal EU as the second pre-signal SWb when the level of the upper envelope signal EU is greater than or equal to the level of the lower envelope signal EL (EU ≥ EL). On the other hand, when the level of the upper envelope signal EU is less than the level of the lower envelope signal EL (EU < EL), the upstream selector circuit 8b compulsorily sets the level of the second pre-signal SWb to the ground level (0 Volt in the present example).

As described above, when the level of the upper envelope signal EU is greater than or equal to the level of the lower envelope signal EL (EU ≥ EL), the upstream selector circuit 8b determines that no adjacent interference wave interferes with the upper sideband WU irrespective of whether any adjacent interference wave is interfering with the lower sideband WL. Then, the upstream selector circuit 8b outputs the upper envelope signal EU as the second pre-signal SWb.

On the other hand, when the level of the upper envelope signal EU is less than the level of the lower envelope signal EL (EU < EL), the upstream selector circuit 8b determines that an adjacent interference wave is likely interfering with the lower sideband WL, and thus does not output the lower envelope signal EL as the second pre-signal SWb. Furthermore, suppose that the lower sideband WL is interfered with an adjacent wave. In this case, the adjacent interference wave may also affect the upper envelope signal EU, so that the signal may be mixed with a so-called noise component or its waveform may be distorted. Thus, the upstream selector circuit 8b does not simply output the upper envelope signal EU as the second pre-signal SWb but compulsorily sets the second pre-signal SWb to the ground level, thereby eliminating the effects of the adjacent interference wave.

The quick-charge slow-discharge circuit 6, which is equivalent to the peak hold section 6 shown in Fig. 2(a), is formed of a charge and discharge circuit with a discharge time constant greater than its charge time constant. The quick-charge slow-discharge circuit 6 performs a fast charging operation when the first pre-signal SWa is increasing from the ground level (i.e., during its rising cycle), and slowly discharges the charged voltage attained by the fast charging operation when the level of the first pre-signal SWa is decreasing (i.e., during its falling cycle). In this manner, the quick-charge slow-discharge circuit 6 smoothes a high-frequency component (i.e., a higher frequency component than the aforementioned discharge time constant) contained in the first pre-signal SWa, and then outputs the smoothed signal as the first smoothing signal Sma.

As described above, the quick-charge slow-discharge circuit 6 performs the quick-charge slow-discharge operation on the first pre-signal SWa. Under a reception condition in which no adjacent interference waves are interfering with the lower sideband WL and the upper sideband WU, this operation allows for producing the first smoothing signal Sma indicative of the intrinsic reception sensitivity that has been affected by no adjacent interference.

On the other hand, in a reception condition, the lower sideband WL may be interfered with no adjacent interference waves but the upper sideband WU may be interfered with an adjacent interference wave. In this case, the quick-charge slow-discharge operation is also performed on the first pre-signal SWa having been set at the aforementioned ground level. This allows for producing the first smoothing signal Sma indicative of the corrected reception sensitivity from which the effects of the adjacent interference has been eliminated.

Furthermore, under a reception condition in which the lower sideband WL is interfered with an adjacent interference wave but the upper sideband WU is interfered with no adjacent interference waves, the first smoothing signal Sma is produced which has been affected by the adjacent interference.

Furthermore, under a reception condition in which the lower sideband WL and the upper sideband WU are interfered with adjacent interference waves, the first smoothing signal Sma is produced which has been affected by the adjacent interferences.

The quick-charge slow-discharge circuit 7, which is equivalent to the peak hold section 7 shown in Fig. 2(a), is formed of a charge and discharge circuit with a discharge time constant greater than its charge time constant. The quick-charge slow-discharge circuit 7 performs a fast charging operation when the second pre-signal SWb is increasing from the ground level (i.e., during its rising cycle), and slowly discharges the charged voltage attained by the fast charging operation when the level of the second pre-signal SWb is decreasing (i.e., during its falling cycle). In this manner, the quick-charge slow-discharge circuit 7 smoothes a high-frequency component (i.e., a higher frequency component than the aforementioned discharge time constant) contained in the second pre-signal SWb, and then outputs the smoothed signal as the second smoothing signal Smb.

As described above, the quick-charge slow-discharge circuit 7 performs the quick-charge slow-discharge operation on the second pre-signal SWb. Under a reception condition in which no adjacent interference waves are interfering with the lower sideband WL and the upper sideband WU, this operation allows for producing the second smoothing signal Smb indicative of the intrinsic reception sensitivity that has been affected by no adjacent interference.

On the other hand, in a reception condition, the upper sideband WU may be interfered with no adjacent interference waves but the lower sideband WL may be interfered with an adjacent interference wave. In this case, the quick-charge slow-discharge operation is also performed on the second pre-signal SWb having been set at the aforementioned ground level. This allows for producing the second smoothing signal Smb indicative of the corrected reception sensitivity from which the effects of the adjacent interference has been eliminated.

Furthermore, under a reception condition in which the upper sideband WU is interfered with an adjacent interference wave but the lower sideband WL is interfered with no adjacent interference waves, the second smoothing signal Smb which has been affected by the adjacent interference is produced.

Furthermore, under a reception condition in which the upper sideband WU and the lower sideband WL are interfered with adjacent interference waves, the second smoothing signal Smb is produced which has been affected by the adjacent interferences.

The output stage selector circuit 8c sequentially compares instantaneous amplitude levels between the first and second smoothing signals Sma and Smb, and selectively outputs the smoothing signal of the lower level as expressed by the equations (3a) and (3b) below. The S meter signal SMT indicative of an accurate reception sensitivity with the voltage level is produced for output.

<u>Equation 3</u>

$$SMT = Sma \text{ when } Sma \leq Smb \qquad ...(3a)$$

$$SMT = Smb \text{ when } Sma > Smb \qquad ...(3b).$$

As described above, the output stage selector circuit 8c performs the selecting operation. This operation is to select the smoothing signal (the smoothing signal of the lower level) from which the effects of the adjacent interference have been more thoroughly eliminated among the first smoothing signal Sma and the second smoothing signal Smb from which the effects of the adjacent interference have been already sufficiently eliminated by the end of the processing of the quick-charge slow-discharge circuits 6 and 7. It is thus possible to produce a more accurate S meter signal SMT.

A description will now be made to the operation of the reception sensitivity detector of the present example configured as described above.

First, with reference to Fig. 5, a description will be made to a case where the lower sideband WL and the upper sideband WU are interfered with no adjacent interference waves, i.e., a reception condition in which the sidebands are not affected by adjacent interference waves.

When the lower sideband WL and the upper sideband WU shown in Fig. 4(a) are interfered with no adjacent interference waves, the envelope of the IF signal SIF is generally flat as illustrated in Fig. 5. Furthermore, the lower signal component SL and the upper signal component SU which are extracted via the narrowband filters 2 and 3 having the passband widths F2 and F3 as shown in Figs. 4(b) and (c) are frequency shifted generally in the directions opposite to each other with respect to the center frequency fo. This causes the lower envelope signal EL produced based on the lower signal component SL and the upper envelope signal EU produced based on the upper signal component SU to have waveforms which are reversed in phase with respect to each other.

Furthermore, the upstream selector circuits 8a and 8b compare levels between the lower envelope signal EL and the upper envelope signal EU, thereby allowing the first pre-signal SWa and the second pre-signal SWb to vary following the lower envelope signal EL and the upper signal component SU.

Then, the first pre-signal SWa and the second pre-signal SWb are subjected to the quick-charge slow-charge operation at the quick-charge slow-discharge circuits 6 and 7, thereby producing the first smoothing signal Sma and the second smoothing signal Smb which have been smoothed as illustrated. The downstream selector circuit 8c selectively outputs the smoothing signal of the lower level, thereby producing the S meter signal SMT indicative of a correct reception sensitivity.

As described above, when the lower sideband WL and the upper sideband WU are interfered with no adjacent interference waves, the S meter signal SMT is produced which is indicative of a correct reception sensitivity. In accordance with the voltage level of the S meter signal SMT, the soft mute circuit 13a, the separation control circuit 13b, and the high-cut circuit 13c in the automatic reception control circuit 13 provide the automatic reception control to the demodulated signal Sdet. Even in the presence of fading or the like, the output signal Sout that can provide the user with reproduced sound with good sound quality is produced for output.

Now, with reference to Fig. 6, a description will be made to an exemplary operation performed when the IF signal SIF is interfered with an interference wave due to adjacent interference during distance reception.

However, by way of example, a description will be made to a case where an upper sub-band WU is interfered with an adjacent broadcast channel wave which has a carrier frequency that is 100 kHz higher than the center frequency fo of the band-pass filter 10 and which has a maximum frequency shift of +/- 75 kHz around the carrier frequency. That is, a description will be made to the interference with an interference wave NZU shown in Fig. 1(e).

When the upper sub-band WU is interfered with an adjacent broadcast channel wave as an adjacent interference wave, the envelope of the desired wave component of the IF signal SIF is superimposed with a noise component of the interference wave as shown in Fig. 6.

When the upper envelope signal EU is supplied to the upper and lower narrowband filters 2,3 and then its envelope is detected at the envelope detection circuits 4 and 5, the signal EU takes the waveform of the desired signal that is directly mixed (imposed) with the interfering adjacent interference wave as a noise component. Thus, the lower envelope signal EL is not directly affected by the adjacent interference wave but takes a waveform of the desired signal that is mixed (imposed) with a noise component or distorted.

Then, the instantaneous amplitude levels are compared between the lower envelope signal EL and the upper envelope signal EU at the upstream selector sections 8a and 8b.

Here, when the level of the lower envelope signal EL is greater than the level of the upper envelope signal EU, the upstream selector section 8a outputs the lower envelope signal EL as the first pre-signal SWa in accordance with the relation between the Equations (1a) and (2b) above. Additionally, the upstream selector section 8b compulsorily sets the second pre-signal SWb to the ground level (0 Volt).

Furthermore, when the level of the lower envelope signal EL is less than the level of the upper envelope signal EU, the upstream selector section 8a compulsorily sets the first pre-signal SWa to the ground level (0 Volt) in accordance with the relation between the Equations (1b) and (2a) above. Additionally, the upstream selector section 8b outputs the upper envelope signal EU as the second pre-signal SWb.

Therefore, when the adjacent interference wave from an adjacent broadcast channel interferes with the upper sub-band WU, the first pre-signal SWa serves as the lower envelope signal EL when the adjacent interference wave has no effects thereon. However, the first pre-signal SWa is compulsorily set to the ground level (0 Volt) even when indirectly the adjacent interference wave has effects thereon.

Furthermore, the second pre-signal SWb takes generally the same waveform as the upper envelope signal EU which is mixed with a noise component from the adjacent interference wave. Additionally, the second pre-signal SWb is compulsorily set to the ground level (0 Volt) when the first pre-signal SWa is not affected by any adjacent interference wave.

Then, the first pre-signal SWa and the second pre-signal SWb are each subjected to the quick-charge slow-discharge operation at the quick-charge slow-discharge circuits 6 and 7, and thereby smoothed into the first and second smoothing signals Sma and Smb, as illustrated, for supply to the downstream selector section 8c.

Then, the downstream selector section 8c selects the smoothing signal of the lower level. This allows for selecting the first smoothing signal Sma having been produced based on the modulated wave component (the lower signal component) SL in the lower sideband WL which has been affected by almost no adjacent interference. The S meter signal SMT is thus produced.

Note that the detailed description will not be made to the operation performed when an adjacent broadcast channel wave interferes with the lower sub-band WL, i.e., when an interference wave NZL shown in Fig. 1(e) interferes with the lower sub-band WL. However, respective waveforms appearing when the interference wave NZL interferes with the lower sub-band WL are obtained by changing signs between the envelope signals EL and EU shown in Fig. 6, by changing signs between the pre-signals SWa and SWb, and by changing signs between the smoothing signals Sma and Smb.

Furthermore, in such a case, the quick-charge slow-discharge circuit 7 produces the smoothing signal Smb which has a waveform (the waveform of the lower level) like the smoothing signal Sma shown in Fig. 6. Furthermore, the quick-charge slow-discharge circuit 6 produces the smoothing signal Sma which has a waveform (the waveform of the higher level) like the smoothing signal Smb shown in Fig. 6. Thus, the smoothing signal Smb of the lower level to be produced in the quick-charge slow-discharge circuit 7 is selected at the downstream selector section 8c, thereby producing the S meter signal SMT indicative of accurate reception sensitivity.

Furthermore, suppose that an adjacent interference wave interferes with both the lower sideband WL and the upper sideband WU. In this case, an accurate S meter signal SMT may be inevitably difficult to produce. However, the reception sensitivity detector of the present example can produce a more accurate S meter signal SMT than the conventional reception sensitivity detector when their performances are compared.

That is, the maximum frequency shift of an adjacent interference wave interfering with the lower sideband WL is determined to be generally +/- 75 kHz around its carrier frequency, and the maximum frequency shift of an adjacent interference wave interfering with the upper sideband WU is determined to be generally +/- 75 kHz around its carrier frequency.

Even in this case, the maximum frequency shift of an actual adjacent interference wave may be often within a frequency range narrower than +/- 75 kHz. Thus, according to the reception sensitivity detector of the present example, the first and second pre-signals SWa and SWb are set to the ground level (0 Volt) to eliminate the effects of the interference wave, and then subjected to the quick-charge slow-discharge operation at the quick-charge slow-discharge circuits 6 and 7.

This allows the reception sensitivity detector to operate to reduce the effects of an actual adjacent interference wave, thereby making it possible to produce a more accurate S meter signal SMT than the conventional reception sensitivity detector.

As described above, according to the reception sensitivity detector of the present example, the lower narrowband filter 2 and the envelope detection circuit 4 produce the lower envelope signal EL indicative of whether or not an interference wave interferes with the lower sideband WL. Furthermore, the upper narrowband filter 3 and the envelope detection circuit 5 produce the upper envelope signal EU indicative of whether or not an interference wave interferes with the upper sideband WU.

As shown in Equations (1a), (1b), (2a), and (2b) above, the upstream selector sections 8a and 8b compare levels between the lower envelope signal EL and the upper envelope signal EU. Then, the pre-signals SWa and SWb which have been processed to eliminate the effects of the interference wave based on the comparison result is supplied to the quick-charge slow-discharge circuits 6 and 7. Thus, the downstream selector circuit 8c selects the smoothing signal of the lower level between the first and second smoothing signals Sma and Smb produced in the quick-charge slow-discharge circuits 6 and 7, thereby producing an accurate S meter signal SMT.

That is, when the level of the lower envelope signal EL is greater than the level of the upper envelope signal EU, the upstream selector section 8a employs the lower envelope signal EL as the first pre-signal SWa. Furthermore, when the level of the lower envelope signal EL is less than the level of the upper envelope signal EU, the first pre-signal SWa is compulsorily set to the ground level to thereby eliminate the effects of the interference wave thereon and then supplied to the quick-charge slow-discharge circuit 6.

On the other hand, when the level of the upper envelope signal EU is greater than the level of the lower envelope signal EL, the upstream selector section 8b employs the upper envelope signal EU as the second pre-signal SWb. Furthermore, when the level of the upper envelope signal EU is less than the level of the lower envelope signal EL, the second pre-signal SWb is compulsorily set to the ground level to thereby eliminate the effects of the interference wave, and then supplied to the quick-charge slow-discharge circuit 6.

As described above, the upstream selector sections 8a and 8b eliminate in advance the effects of an interference wave on and thereby produce the first and second pre-signals SWa and SWb, which are in turn held at the quick-charge slow-discharge circuits 6 and 7. It is thus possible to produce the first and second smoothing signals Sma and Smb from which the effects of the interference wave have been suppressed. Then, the downstream selector circuit 8c selects the smoothing signal of the lower level between the first and second smoothing signals Sma and Smb, thereby producing an accurate S meter signal SMT.

Note that the present example includes two branches, a first branch and a second branch, as a set of (a pair of) processing branches. The first branch has the narrowband filter 2, the envelope detection section 4, the upstream selector section 8a, and the quick-charge slow-discharge circuit 6 for detecting the presence of an interference wave interfering with the lower sideband WL. The second branch has the narrowband filter 3, the envelope detection section 5, the upstream selector section 8b, and the quick-charge slow-discharge circuit 7 for detecting the presence of an interference wave interfering with the upper sideband WU.

Then, as the S meter signal SMT, the downstream selector section 8c selects the one of the lower level of the smoothing signals Sma and Smb produced in the quick-charge slow-discharge circuits 6 and 7. However, as a modified example, another processing branch which is configured in the same manner may also be added, so that as the S meter signal SMT, the downstream selector section 8c selects the smoothing signal of the lowest level among those smoothing signals produced in the quick-charge slow-discharge circuit of each processing branch.

Furthermore, the passband widths of the lower narrowband filter and the upper narrowband filter of one processing branch may be defined to be different in frequency range from those of another processing branch. This makes it possible to produce the S meter signal SMT that is indicative of a more accurate reception sensitivity.

However, this modified example can also be desirably configured such that the passband widths of the lower narrowband filter and the upper narrowband filter of each processing branch should contain at least the center frequency (carrier frequency) fo and be symmetric with respect to the center frequency fo. Furthermore, the passband widths may be defined such that each lower narrowband filter does not pass an adjacent interference wave interfering with the upper sideband WU, and each upper narrowband filter does not pass an adjacent interference wave interfering with the lower sideband WL.

**Claims**

1. A reception sensitivity detector for detecting a reception sensitivity from a modulated wave signal, the reception sensitivity detector (1) comprising:

   - lower narrowband filter means (2) having a passband width (F2) of a predetermined low frequency range including a carrier frequency (fo) of the modulated wave signal, the lower narrowband filter means (2) extracting a lower signal component (SL) within the passband width from the modulated wave signal;
   - upper narrowband filter means (3) having a passband width (F3) of a predetermined high frequency range including the carrier frequency (fo) of the modulated wave signal, the upper narrowband filter means (3) extracting an upper signal component (SU) within the passband width from the modulated wave signal;

- lower envelope detection means (4) for detecting an envelope (EL) of the lower signal component (SL);
- upper envelope detection means (5) for detecting an envelope (EU) of the upper signal component (SU);
- first peak hold means (6) for holding a peak of a lower envelope signal detected in the lower envelope detection means (4) to thereby produce a smoothing signal (Sma);
- second peak hold means (7) for holding a peak of an upper envelope signal (EL) detected in the upper envelope detection means (5) to thereby produce a smoothing signal (Smb);

**characterized by**
selector means (8) for selecting a smoothing signal of a lower level between the smoothing signals (Sma, Smb) produced in the first and second peak hold means (6, 7) to produce a reception sensitivity signal (SMT) indicative of reception sensitivity.

2. The detector according to claim 1,
wherein the detector further comprises:

- first upstream selector means (8a) for comparing levels between a lower envelope signal (EL) detected in the lower envelope detection means (4) and an upper envelope signal (EU) detected in the upper envelope detection means (5), wherein the lower envelope signal is employed as a first pre-signal when the level of the lower envelope signal is greater than the level of the upper envelope signal, while a first pre-signal of a ground level is produced when the level of the lower envelope signal is less than the level of the upper envelope signal;
- second upstream selector means (8b) for comparing the levels between the lower envelope signal (EL) detected in the lower envelope detection means (4) and the upper envelope signal (EU) detected in the upper envelope detection means (5), wherein the upper envelope signal is employed as a second pre-signal when the level of the upper envelope signal is greater than the level of the lower envelope signal, while a second pre-signal of the ground level is produced when the level of the upper envelope signal is less than the level of the lower envelope signal;
- first quick-charge slow-discharge means (6) for producing a smoothing signal (Sma) by performing a quick-charge slow-discharge operation on the first pre-signal produced in the first upstream selector means (8a);
- second quick-charge slow-discharge means (7) for producing a smoothing signal (Smb) by performing a quick-charge slow-discharge operation on the second pre-signal produced in the second upstream selector means (8b); and
- downstream selector means (8c) for selecting a smoothing signal of a lower level between the smoothing signals (Sma, Smb) produced in the first and second quick-charge slow-discharge means (6, 7) to produce a reception sensitivity signal (SMT) indicative of reception sensitivity.

3. A receiver comprising a detector according to claim 1 or 2 and automatic reception control means (13) for providing automatic reception control to a detection output detected based on the modulated wave signal in accordance with the reception sensitivity signal (SMT) produced by the reception sensitivity detector according to claim 1 or 2.

4. A reception sensitivity detection method for detecting a reception sensitivity from a modulated wave signal,
the method comprising the following steps:

- a lower narrowband filter step (2) of extracting a lower signal component (SL) within a passband width (F2) from the modulated wave signal, the passband width (F2) having a predetermined low frequency range including a carrier frequency (fo) of the modulated wave signal;
- an upper narrowband filter step (3) of extracting an upper signal component (SU) within a passband width (F3) from the modulated wave signal, the passband width (F3) having a predetermined high frequency range including the carrier frequency (fo) of the modulated wave signal;
- a lower envelope detection step (4) of detecting an envelope (EL) of the lower signal component;
- an upper envelope detection step (5) of detecting an envelope (EU) of the upper signal component;
- a first peak hold step (6) of holding a peak of a lower envelope signal detected in the lower envelope detection step to thereby produce a smoothing signal (Sma) ;
- a second peak hold step (7) of holding a peak of an upper envelope signal detected in the upper envelope detection step to thereby produce a smoothing signal (Smb);

**characterized by**
a selector step (8) of selecting a smoothing signal of a lower level between the smoothing signals (Sma, Smb) produced in the first and second peak hold steps (6, 7) to produce a reception sensitivity signal (SMT) indicative of reception sensitivity.

5. The detection method according to claim 4,
wherein the detection method further comprises the following steps:

- a first upstream selector step (8a) of comparing levels between a lower envelope signal (EL) detected in the lower envelope detection step (4) and an upper envelope signal (EU) detected in the upper envelope detection step (5), wherein the lower envelope signal is employed as a first pre-signal when the level of the lower envelope signal is greater than the level of the upper envelope signal, while a first pre-signal of a ground level is produced when the level of the lower envelope signal is less than the level of the upper envelope signal;
- a second upstream selector step (8b) of comparing levels between the lower envelope signal (EL) detected in the lower envelope detection step (4) and the upper envelope signal (EU) detected in the upper envelope detection step (5), wherein the upper envelope signal is employed as a second pre-signal when the level of the upper envelope signal is greater than the level of the lower envelope signal, while a second pre-signal of a ground level is produced when the level of the upper envelope signal is less than the level of the lower envelope signal;
- a first quick-charge slow-discharge step (6) of producing a smoothing signal (Sma) by performing a quick-charge slow-discharge operation on the first pre-signal produced in the first upstream selector step (8a);
- a second quick-charge slow-discharge step (7) of producing a smoothing signal (Smb) by performing a quick-charge slow-discharge operation on the second pre-signal produced in the second upstream selector step (8b); and
- a downstream selector step (8c) of selecting a smoothing signal of a lower level between the smoothing signals (Sma, Smb) produced in the first and second quick-charge slow-discharge steps (6, 7) to produce a reception sensitivity signal (SMT) indicative of reception sensitivity.

6. A reception method comprising an automatic reception control step (13) of providing automatic reception control to a detection output (Sout) detected based on the modulated wave signal in accordance with the reception sensitivity signal (SMT) produced according to the reception sensitivity detection method of claim 4 or 5.

**Patentansprüche**

1. Empfangsempfindlichkeits-Detektor zum Detektieren einer Empfangsempfindlichkeit von einem modulierten Wellensignal, wobei der Empfangsempfindlichkeits-Detektor (1) folgendes aufweist:

- eine Filtereinrichtung (2) für ein unteres Schmalband, die eine Durchlaßbandbreite (F2) für einen vorbestimmten niedrigen Frequenzbereich aufweist, der eine Trägerfrequenz (fo) des modulierten Wellensignals beinhaltet, wobei die Filtereinrichtung (2) für das untere Schmalband eine untere Signalkomponente (SL) innerhalb der Durchlaßbandbreite von dem modulierten Wellensignal extrahiert;
- eine Filtereinrichtung (3) für ein oberes Schmalband, die eine Durchlaßbandbreite (F3) für einen vorbestimmten hohen Frequenzbereich aufweist, der die Trägerfrequenz (fo) des modulierten Wellensignals beinhaltet, wobei die Filtereinrichtung (3) für das obere Schmalband eine obere Signalkomponente (SU) innerhalb der Durchlaßbandbreite von dem modulierten Wellensignal extrahiert;
- eine Erfassungseinrichtung (4) für eine untere Hüllkurve, zum Detektieren einer Hüllkurve (EL) der unteren Signalkomponente (SL);
- eine Erfassungseinrichtung (5) für eine obere Hüllkurve, zum Detektieren einer Hüllkurve (EU) der oberen Signalkomponente (SU);
- eine erste Peak-Halteeinrichtung (6) zum Halten eines Peaks eines unteren Hüllkurvensignals, das in der Erfassungseinrichtung (4) für die untere Hüllkurve detektiert worden ist, um dadurch ein Glättungssignal (Sma) zu erzeugen;
- eine zweite Peak-Halteeinrichtung (7) zum Halten eines Peaks eines oberen Hüllkurvensignals (EL), das in der Erfassungseinrichtung (5) für die obere Hüllkurve detektiert worden ist, um dadurch ein Glättungssignal (Smb) zu erzeugen;

**gekennzeichnet durch**:

- eine Wähleinrichtung (8) zum Auswählen eines Glättungssignals mit einem niedrigeren Pegel aus den in der ersten und der zweiten Peak-Halteeinrichtung (6, 7) erzeugten Glättungssignalen (Sma, Smb), um ein die Empfangsempfindlichkeit anzeigendes Empfangsempfindlichkeitssignal (SMT) zu erzeugen.

2. Detektor nach Anspruch 1,
wobei der Detektor ferner folgendes aufweist:

- eine erste vorgeschaltete Wähleinrichtung (8a) zum Vergleichen von Pegeln zwischen einem unteren Hüllkurvensignal (EL), das in der Erfassungseinrichtung (4) für die untere Hüllkurve detektiert wird, und einem oberen Hüllkurvensignal (EU), das in der Erfassungseinrichtung (5) für die obere Hüllkurve detektiert wird, wobei das untere Hüllkurvensignal als erstes Vor-Signal verwendet wird, wenn der Pegel des unteren Hüllkurvensignals höher ist als der Pegel des oberen Hüllkurvensignals, wobei ein erstes Vor-Signal mit einem Masse-Pegel erzeugt wird, wenn der Pegel des unteren Hüllkurvensignals niedriger ist als der Pegel des oberen Hüllkurvensignals;
- eine zweite vorgeschaltete Wähleinrichtung (8b) zum Vergleichen der Pegel zwischen dem unteren Hüllkurvensignal (EL), das in der Erfassungseinrichtung (5) für die obere Hüllkurve detektiert wird, und dem oberen Hüllkurvensignal (EU), das in der Erfassungseinrichtung (5) für die obere Hüllkurve detektiert wird, wobei das obere Hüllkurvensignal als zweites Vor-Signal verwendet wird, wenn der Pegel des oberen Hüllkurvensignals höher ist als der Pegel des unteren Hüllkurvensignals, wobei ein zweites Vor-Signal mit Masse-Pegel erzeugt wird, wenn der Pegel des oberen Hüllkurvensignals niedriger ist als der Pegel des unteren Hüllkurvensignals;
- eine erste schnell ladende und langsam entladende Einrichtung (6) zum Erzeugen eines Glättungssignals (Sma) durch Ausführen eines Vorgangs mit schnellem Laden und langsamem Entladen bei dem ersten Vor-Signal, das in der ersten vorgeschalteten Wähleinrichtung (8a) erzeugt wird;
- eine zweite schnell ladende und langsam entladende Einrichtung (7) zum Erzeugen eines Glättungssignals (Smb) durch Ausführen eines Vorgangs mit schnellem Laden und langsamen Entladen bei dem zweiten Vor-Signal, das in der zweiten vorgeschalteten Wähleinrichtung (8b) erzeugt wird; und
- eine nachgeschaltete Wähleinrichtung (8c) zum Auswählen eines Glättungssignals mit einem niedrigeren Pegel aus den in der ersten und der zweiten schnell ladenden und langsam entladenden Einrichtung (6, 7) erzeugten Glättungssignalen (Sma, Smb), um dadurch ein die Empfangsempfindlichkeit anzeigendes Empfangsempfindlichkeitssignal (SMT) zu erzeugen.

3. Empfänger, der einen Detektor nach Anspruch 1 oder 2 und eine automatische Empfangssteuereinrichtung (13) aufweist, um eine automatische Empfangssteuerung bei einem auf der Basis des modulierten Wellensignals detektierten Erfassungsausgangssignal in Abhängigkeit von dem von dem Empfangsempfindlichkeits-Detektor nach Anspruch 1 oder 2 erzeugten Empfangsempfindlichkeitssignal (SMT) vorzunehmen.

4. Empfangsempfindlichkeits-Detektionsverfahren zum Detektieren einer Empfangsempfindlichkeit von einem modulierten Wellensignal,
wobei das Verfahren folgende Schritte aufweist:

- einen Filterschritt (2) für ein unteres Schmalband, in dem eine untere Signalkomponente (SL) innerhalb einer Durchlaßbandbreite (F2) von dem modulierten Wellensignal extrahiert wird, wobei die Durchlaßbandbreite (F2) einen vorbestimmten niedrigen Frequenzbereich aufweist, der eine Trägerfrequenz (fo) des modulierten Wellensignals beinhaltet;
- einen Filterschritt (3) für ein oberes Schmalband, in dem eine obere Signalkomponente (SU) innerhalb einer Durchlaßbandbreite (F3) von dem modulierten Wellensignal extrahiert wird, wobei die Durchlaßbandbreite (F3) einen vorbestimmten hohen Frequenzbereich aufweist, der die Trägerfrequenz (fo) des modulierten Wellensignal beinhaltet;
- einen Erfassungsschritt (4) für eine untere Hüllkurve, zum Detektieren einer Hüllkurve (EL) der unteren Signalkomponente;
- einen Erfassungsschritt (5) für eine obere Hüllkurve, zum Detektieren einer Hüllkurve (EU) der oberen Signalkomponente;
- einen ersten Peak-Halteschritt (6) zum Halten eines Peaks eines unteren Hüllkurvensignals, das in dem Erfassungsschritt für die untere Hüllkurve detektiert worden ist, um dadurch ein Glättungssignal (Sma) zu erzeugen;
- einen zweiten Peak-Halteschritt (7) zum Halten eines Peaks eines oberen Hüllkurvensignals, das in dem Erfassungsschritt für die obere Hüllkurve detektiert worden ist, um dadurch ein Glättungssignal (Smb) zu erzeugen;

**gekennzeichnet durch**:

- einen Auswählschritt (8) zum Auswählen eines Glättungssignals mit einem niedrigeren Pegel aus den in dem ersten und dem zweiten Peak-Halteschritt (6, 7) erzeugten Glättungssignalen (Sma, Smb), um ein die Empfangsempfindlichkeit anzeigendes Empfangsempfindlichkeitssignal (SMT) zu erzeugen.

**5.** Detektionsverfahren nach Anspruch 4,
wobei das Detektionsverfahren ferner folgende Schritte aufweist:

- einen ersten vorgeschalteten Auswählschritt (8a) zum Vergleichen von Pegeln zwischen einem unteren Hüllkurvensignal (EL), das in dem Erfassungsschritt (4) für die untere Hüllkurve detektiert wird, und einem oberen Hüllkurvensignal (EU), das in dem Erfassungsschritt (5) für die obere Hüllkurve detektiert wird, wobei das untere Hüllkurvensignal als erstes Vor-Signal verwendet wird, wenn der Pegel des unteren Hüllkurvensignals höher ist als der Pegel des oberen Hüllkurvensignals, wobei ein erstes Vor-Signal mit einem Masse-Pegel erzeugt wird, wenn der Pegel des unteren Hüllkurvensignals niedriger ist als der Pegel des oberen Hüllkurvensignals;
- einen zweiten vorgeschalteten Auswählschritt (8b) zum Vergleichen von Pegeln zwischen dem unteren Hüllkurvensignal (EL), das in dem Erfassungsschritt (4) für die untere Hüllkurve detektiert wird, und dem oberen Hüllkurvensignal (EU), das in dem Erfassungsschritt (5) für die obere Hüllkurve detektiert wird, wobei das obere Hüllkurvensignal als zweites Vor-Signal verwendet wird, wenn der Pegel des oberen Hüllkurvensignals höher ist als der Pegel des unteren Hüllkurvensignals, wobei ein zweites Vor-Signal mit einem Masse-Pegel erzeugt wird, wenn der Pegel des oberen Hüllkurvensignals niedriger ist als der Pegel des unteren Hüllkurvensignals;
- einen ersten Schritt (6) zum schnellen Laden und langsamen Entladen, zum Erzeugen eines Glättungssignals (Sma) durch Ausführen eines Vorgangs mit schnellem Laden und langsamem Entladen bei dem ersten Vor-Signal, das in dem ersten vorgeschalteten Auswählschritt (8a) erzeugt wird;
- einen zweiten Schritt (7) zum schnellen Laden und langsamen Entladen, zum Erzeugen eines Glättungssignals (Smb) durch Ausführen eines Vorgangs mit schnellem Laden und langsamen Entladen bei dem zweiten Vor-Signal, das in dem zweiten vorgeschalteten Auswählschritt (8b) erzeugt wird; und
- einen nachgeschalteten Auswählschritt (8c) zum Auswählen eines Glättungssignals mit einem niedrigeren Pegel aus den in dem ersten und dem zweiten Schritt (6, 7) zum schnellen Laden und langsamen Entladen erzeugten Glättungssignalen (Sma, Smb), um dadurch ein die Empfangsempfindlichkeit anzeigendes Empfangsempfindlichkeitssignal (SMT) zu erzeugen.

**6.** Empfangsverfahren, das einen automatischen Empfangssteuerungsschritt (13) aufweist, um eine automatische Empfangssteuerung bei einem auf der Basis des modulierten Wellensignals detektierten Erfassungsausgangssignal (Sout) in Abhängigkeit von dem von dem Empfangsempfindlichkeits-Detektionsverfahren nach Anspruch 4 oder 5 erzeugten Empfangsempfindlichkeitssignal (SMT) vorzunehmen.

## Revendications

**1.** Détecteur de sensibilité de réception destiné à détecter une sensibilité de réception à partir d'un signal d'onde modulé, le détecteur de sensibilité de réception (1) comprenant:

- un moyen de filtre à bande étroite inférieure (2) présentant une largeur de bande passante (F2) d'une plage de basses fréquences prédéterminée comprenant une fréquence porteuse (fo) du signal d'onde modulé, le moyen de filtre à bande étroite inférieure (2) extrayant une composante de signal inférieure (SL) à l'intérieur de la largeur de bande passante à partir du signal d'onde modulé;
- un moyen de filtre à bande étroite supérieure (3) présentant une largeur de bande passante (F3) d'une plage de hautes fréquences prédéterminée comprenant la fréquence porteuse (fo) du signal d'onde modulé, le moyen de filtre à bande étroite supérieure (3) extrayant une composante de signal supérieure (SU) à l'intérieur de la largeur de bande passante à partir du signal d'onde modulé;
- un moyen de détection d'enveloppe inférieure (4) pour détecter une enveloppe (EL) de la composante de signal inférieure (SL);
- un moyen de détection d'enveloppe supérieure (5) pour détecter une enveloppe (EU) de la composante de signal supérieure (SU);
- un premier moyen de maintien de crête (6) pour maintenir une crête d'un signal d'enveloppe inférieure détecté dans le moyen de détection d'enveloppe inférieure (4) afin d'ainsi produire un signal de lissage (Sma);
- un second moyen de maintien de crête (7) pour maintenir une crête d'un signal d'enveloppe supérieure (EU) détecté dans le moyen de détection d'enveloppe supérieure (5) afin d'ainsi produire un signal de lissage (Smb);
**caractérisé par**:

un moyen de sélection (8) pour sélectionner un signal de lissage d'un niveau inférieur entre les signaux de lissage (Sma, Smb) produits dans les premier et second moyens de maintien de crête (6, 7) afin de produire un signal de sensibilité de réception (SMT) indicatif d'une sensibilité de réception.

2. Détecteur selon la revendication 1, dans lequel le détecteur comprend en outre:

- un premier moyen de sélection amont (8a) pour comparer des niveaux entre un signal d'enveloppe inférieure (EL) détecté dans le moyen de détection d'enveloppe inférieure (4) et un signal d'enveloppe supérieure (EU) détecté dans le moyen de détection d'enveloppe supérieure (5), dans lequel le signal d'enveloppe inférieure est utilisé en tant que premier pré-signal lorsque le niveau du signal d'enveloppe inférieure est supérieur au niveau du signal d'enveloppe supérieure, tandis qu'un premier pré-signal d'un niveau au sol est produit lorsque le niveau du signal d'enveloppe inférieure est inférieur au niveau du signal d'enveloppe supérieure;

- un second moyen de sélection amont (8b) pour comparer les niveaux entre le signal d'enveloppe inférieure (EL) détecté dans le moyen de détection d'enveloppe inférieure (4) et le signal d'enveloppe supérieure (EU) détecté dans le moyen de détection d'enveloppe supérieure (5), dans lequel le signal d'enveloppe supérieure est utilisé en tant que second pré-signal lorsque le niveau du signal d'enveloppe supérieure est supérieur au niveau du signal d'enveloppe inférieure, tandis qu'un second pré-signal du niveau au sol est produit lorsque le niveau du signal d'enveloppe supérieure est inférieur au niveau du signal d'enveloppe inférieure;

- un premier moyen de charge rapide-décharge lente (6) pour produire un signal de lissage (Sma) en exécutant une opération de charge rapide-décharge lente sur le premier pré-signal produit dans le premier moyen de sélection amont (8a);

- un second moyen de charge rapide-décharge lente (7) pour produire un signal de lissage (Smb) en exécutant une opération de charge rapide-décharge lente sur le second pré-signal produit dans le second moyen de sélection amont (8b); et

un moyen de sélection aval (8c) pour sélectionner un signal de lissage d'un niveau inférieur entre les signaux de lissage (Sma, Smb) produits dans les premier et second moyens de charge rapide-décharge lente (6, 7) afin de produire un signal de sensibilité de réception (SMT) indicatif d'une sensibilité de réception.

3. Récepteur comprenant un détecteur selon la revendication 1 ou 2 et un moyen de commande de réception automatique (13) pour fournir une commande de réception automatique à une sortie de détection détectée sur la base du signal d'onde modulé en accord avec le signal de sensibilité de réception (SMT) produit par le détecteur de sensibilité de réception selon la revendication 1 ou 2.

4. Procédé de détection de sensibilité de réception destiné à détecter une sensibilité de réception à partir d'un signal d'onde modulé, le procédé comprenant les étapes suivantes:

- une étape de filtre à bande étroite inférieure (2) consistant à extraire une composante de signal inférieure (SL) à l'intérieur d'une largeur de bande passante (F2) à partir du signal d'onde modulé, la largeur de bande passante (F2) présentant une plage de basses fréquences prédéterminée comprenant une fréquence porteuse (fo) du signal d'onde modulé;

- une étape de filtre à bande étroite supérieure (3) consistant à extraire une composante de signal supérieure (SU) à l'intérieur d'une largeur de bande passante (F3) à partir du signal d'onde modulé, la largeur de bande passante (F3) présentant une plage de hautes fréquences prédéterminée comprenant la fréquence porteuse (fo) du signal d'onde modulé;

- une étape de détection d'enveloppe inférieure (4) consistant à détecter une enveloppe (EL) de la composante de signal inférieure;

- une étape de détection d'enveloppe supérieure (5) consistant à détecter une enveloppe (EU) de la composante de signal supérieure;

- une première étape de maintien de crête (6) consistant à maintenir une crête d'un signal d'enveloppe inférieure détecté dans l'étape de détection d'enveloppe inférieure afin d'ainsi produire un signal de lissage (Sma);

- une seconde étape de maintien de crête (7) consistant à maintenir une crête d'un signal d'enveloppe supérieure détecté dans l'étape de détection d'enveloppe supérieure afin d'ainsi produire un signal de lissage (Smb);

<u>caractérisé par</u>:

EP 1 959 573 B1

une étape de sélection (8) consistant à sélectionner un signal de lissage d'un niveau inférieur entre les signaux de lissage (Sma, Smb) produits dans les première et seconde étapes de maintien de crête (6, 7) afin de produire un signal de sensibilité de réception (SMT) indicatif d'une sensibilité de réception.

5. Procédé de détection selon la revendication 4,
dans lequel le procédé de détection comprend en outre les étapes suivantes:

- une première étape de sélection amont (8a) consistant à comparer les niveaux entre un signal d'enveloppe inférieure (EL) détecté dans l'étape de détection d'enveloppe inférieure (4) et un signal d'enveloppe supérieure (EU) détecté dans l'étape de détection d'enveloppe supérieure (5);

dans lequel le signal d'enveloppe inférieure est utilisé en tant que premier pré-signal lorsque le niveau du signal d'enveloppe inférieure est supérieur au niveau du signal d'enveloppe supérieure, tandis qu'un premier pré-signal d'un niveau au sol est produit lorsque le niveau du signal d'enveloppe inférieure est inférieure au niveau du signal d'enveloppe supérieure;

- une seconde étape de sélection amont (8b) consistant à comparer les niveaux entre le signal d'enveloppe inférieure (EL) détecté dans l'étape de détection d'enveloppe inférieure (4) et le signal d'enveloppe supérieure (EU) détecté dans l'étape de détection d'enveloppe supérieure (5);

dans lequel le signal d'enveloppe supérieure est utilisé en tant que second pré-signal lorsque le niveau du signal d'enveloppe supérieure est supérieur au niveau du signal d'enveloppe inférieure, tandis qu'un second pré-signal d'un niveau au sol est produit lorsque le niveau du signal d'enveloppe supérieure est inférieur au niveau du signal d'enveloppe inférieure;

- une première étape de charge rapide-décharge lente (6) consistant à produire un signal de lissage (Sma) en exécutant une opération de charge rapide-décharge lente sur le premier pré-signal produit dans la première étape de sélection amont (8a);
- une seconde étape de charge rapide-décharge lente (7) consistant à produire un signal de lissage (Smb) en exécutant une opération de charge rapide-décharge lente sur le second pré-signal produit dans la seconde étape de sélection amont (8b); et

une étape de sélection aval (8c) consistant à sélectionner un signal de lissage d'un niveau inférieur entre les signaux de lissage (Sma, Smb) produits dans les première et seconde étapes de charge rapide-décharge lente (6, 7) afin de produire un signal de sensibilité de réception (SMT) indicatif d'une sensibilité de réception.

6. Procédé de réception comprenant une étape de commande de réception automatique (13) consistant à fournir une commande de réception automatique à une sortie de détection (Sout) détectée sur la base du signal d'onde modulé en accord avec le signal de sensibilité de réception (SMT) produit selon le procédé de détection de sensibilité de réception selon la revendication 4 ou 5.

18

*FIG.1 (a)*

FRONT END SECTION — INTERMEDIATE FREQUENCY FILTER AND AMPLIFICATION SECTION — DETECTION SECTION — AMPLIFIER c

a — SMOOTHING RECTIFIER SECTION — b

*FIG.1 (b)*

a

TIME

*FIG.1 (c)*

VOLTAGE

b

TIME

*FIG.1 (d)*

IF CENTER FREQUENCY (DESIRED CARRIER FREQUENCY)

MAXIMUM FREQUENCY SHIFT | MAXIMUM FREQUENCY SHIFT

75kHz | 75kHz

IF FILTER BAND

(LOWER) | f0 | DESIRED WAVE | (UPPER) | FREQUENCY

100kHz | 100kHz

*FIG.1 (e)*

CENTER FREQUNCY OF INTERFERENCE WAVE | CENTER FREQUNCY OF INTERFERENCE WAVE

NZL | NZU

FREQUENCY

f0

75kHz | 75kHz

PRIOR ART

*FIG.2 (a)*

1 : RECEPTION SENSITIVITY DETECTOR

```
          2              SL        4          EL        6         Sma
     ┌──────────┐    ┌──────────┐    ┌──────────┐
     │  LOWER   │    │ ENVELOPE │    │   PEAK   │
     │NARROW BAND│───│DETECTION │───│  HOLD    │──────┐
     │  FILTER  │    │ SECTION  │    │ SECTION  │      │
     └──────────┘    └──────────┘    └──────────┘      │
SIF                                                    │   ┌──────────┐   SMT
 o──┤                                                  ├───│ SELECTOR │──o
     ┌──────────┐    ┌──────────┐    ┌──────────┐      │   │ SECTION  │
     │  UPPER   │ SU │ ENVELOPE │    │   PEAK   │      │   └──────────┘
     │NARROW BAND│───│DETECTION │───│  HOLD    │──────┘
     │  FILTER  │    │ SECTION  │EU  │ SECTION  │      Smb
     └──────────┘    └──────────┘    └──────────┘
          3              5          4            7
```

*FIG.2 (b)*

IF CENTER FREQUENCY

(LOWER)     fo     FREQUENCY (UPPER)

|←——————— BAND WIDTH (W) ———————→|
|←——WL——→|←——WU——→|

*FIG.2 (c)*

F2

FREQUENCY

F3

fo

*FIG.2 (d)*

F2

FREQUENCY

F3

fo

*FIG.2 (e)*

F2

FREQUENCY

F3

fo

20

## FIG.3

EP 1 959 573 B1

LOWER MAXIMUM FREQUENCY SHIFT    UPPER MAXIMUM FREQUENCY SHIFT

*FIG.4 (a)*

IF CENTER FREQUENCY

(LOWER)    fo    FREQUENCY (UPPER)

BAND WIDTH (W)

WL    WU

*FIG.4 (b)*

F2

FREQUENCY

F3

*FIG.4 (c)*

FREQUENCY

FREQUENCY

EP 1 959 573 B1

# FIG.5

# FIG.6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1526642 A